Europäisches Patentamt

European Patent Office

Office européen des brevets

(19)

(11) Veröffentlichungsnummer : **0 464 777 B1**

(12) **EUROPÄISCHE PATENTSCHRIFT**

(45) Veröffentlichungstag der Patentschrift :
**18.10.95 Patentblatt 95/42**

(51) Int. Cl.⁶ : **H03M 1/00**

(21) Anmeldenummer : **91110956.9**

(22) Anmeldetag : **02.07.91**

(54) Schaltungsanordnung zum Annähern einer nichtlinearen Übertragungsfunktion.

(30) Priorität : **03.07.90 DE 4021131**

(43) Veröffentlichungstag der Anmeldung :
**08.01.92 Patentblatt 92/02**

(45) Bekanntmachung des Hinweises auf die
Patenterteilung :
**18.10.95 Patentblatt 95/42**

(84) Benannte Vertragsstaaten :
**AT BE CH DE DK ES FR GB IT LI LU NL SE**

(56) Entgegenhaltungen :
**EP-A- 0 155 046**
**EP-A- 0 231 950**
**FR-A- 2 580 877**

(56) Entgegenhaltungen :
**PROCEEDINGS OF THE INSTITUTION OF ELECTRICAL ENGINEERS Bd. 118, Nr. 6, Juni 1971, Seiten 761-764; COOKE-YARBOROUGH: "Method of handling widely ranging variables in digital data-storage and transmission systems of limited word length"**
**IEEE TRANSACTIONS ON NUCLEAR SCIENCE Bd. NS-27, Nr. 1, Februar 1980, NEW YORK US, Seiten 333-337; HALLGREN ET AL: "New developments in time and pulse height digitizers"**

(73) Patentinhaber : **Zumtobel Aktiengesellschaft Höchster Strasse 8 A-6850 Dornbirn (AT)**

(72) Erfinder : **Altmann, Gerhard Daimlerstrasse 12 W-7987 Weingarten (DE)**
Erfinder : **Urban, Bernd Daimlerstrasse 38 W-7987 Weingarten (DE)**

(74) Vertreter : **Schmidt-Evers, Jürgen, Dipl.-Ing. et al Patentanwälte Mitscherlich & Partner Postfach 33 06 09 D-80066 München (DE)**

EP 0 464 777 B1

**Beschreibung**

Die Erfindung betrifft eine Schaltungsanordnung zum Annähern einer logarithmischen oder antilogarithmischen/exponentiellen Übertragungsfunktion gemäß dem Oberbegriff des Anspruchs 1. Schließlich betrifft die Erfindung ein Beleuchtungssystem gem. Anspruch 9 bei welchem die Helligkeit einer oder mehrerer Lichterzeuger geregelt oder gesteuert wird.

Die Dokumente EP-A-0 231 950, IEEE TRANSACTIONS ON NUCLEAR SCIENCE, Band NS-27, Nr. 1, Februar 1980, Seiten 333-337, HALLGREN et al. "NEW DEVELOPMENTS IN TIME AND PULSE HEIGHT DIGITIZERS" und FR-A-2 580 877 offenbaren Schaltungsanordnungen zum Annähern einer logarithmischen oder antilogarithmischen Übertragungsfunktion bei der Analog-Digital-Wandlung/Umsetzung eines analogen Eingangssignales, wobei eine analoge Referenzgröße und ein analoges Eingangssignal einem Analog-Digital-Wandler zuführbar ist, der Wandler ein digitales Ausgangssignal auf der Basis einer im wesentlichen linearen Umsetzer-/Wandlercharakteristik erzeugt und dem jeweiligen linearen Wandler eine nichtkonstante, von dem analogen Eingangssignal abhängige Referenzgröße vorgebbar ist.

Das menschliche Auge ist, wie das menschliche Gehör nichtlinear empfindlich. Diese Nichtlinearität ist näherungsweise logarithmisch. Der Einsatz von linearen Steuer- oder Regelsystemen für eine erwünschte Helligkeit oder eine erwünschte Lautstärke erzeugt demgemäß kein entsprechend lineares Helligkeits- oder Lautstärkeempfinden in den menschlichen Sinnesorganen. So wird beispielsweise ausgehend von einer vorgegebenen Helligkeit eine Verdoppelung des menschlichen Helligkeitseindruckes durch eine Vervierfachung der elektrischen oder anderweitigen Lichtleistung erreicht. Gleiches gilt für den akustischen Sinneseindruck.

Lineare Regel- und Steuersysteme eignen sich daher nur bedingt zum augengerechten oder hörgerechten Steuern und Regeln von Helligkeit und Lautstärke. Es werden hierfür zum Beispiel analoge Verstärker eingesetzt, die zum einen eine logarithmische Übertragungscharakteristik und andererseits eine exponentielle Übertragungscharakteristik aufweisen. Eine Hintereinanderschaltung dieser analogen Verstärker erzeugt wiederum eine lineare Übertragungscharakteristik. Die genannten logarithmischen oder exponentiellen analogen Verstärker setzen hierbei in der Regel die exponentielle Strom/Spannungscharakteristik einer in Flußrichtung geschalteten Diode oder eines Transistors ein. Ein Operationsverstärker, der eine Diode in Flußrichtung im Rückkopplungszweig oder eine solche in dem Eingangszweig aufweist hat eine logarithmische oder exponentielle Übertragungscharakteristik. Diese ist jedoch aufgrund der starken Temperaturempfindlichkeit der Diodenkennlinie ebenfalls stark temperaturabhängig. Neben der Temperaturabhängigkeit bestehen auch Abgleichprobleme, da die Kennlinien unterschiedlicher Dioden nicht exakt übereinstimmen und somit mehrere parallele Verstärker mit logarithmischer oder exponentieller Kennlinie einen ungenügenden Gleichlauf haben.

Es ist daher Aufgabe der vorliegenden Erfindung eine Schaltungsanordnung zu schaffen, die eine logarithmische oder antilogarithmische (exponentielle) Übertragungscharakteristik aufweist und bei welcher die Temperaturstabilität verbessert ist. Es ist ferner eine Aufgabe der Erfindung ein Verfahren zum Annähern einer beliebig vorgebbaren nichtlinearen Übertragungsfunktion anzugeben, bei welcher die vorgenannten Temperaturprobleme ebenfalls nicht auftreten. Schließlich ist es eine Aufgabe der Erfindung ein Beleuchtungssystem anzugeben, bei welchem die Helligkeit abhängig von einer linear veränderten Führungsgröße augengerecht veränderbar ist.

Die Aufgabe ist bei einer Schaltungsanordnung gemäß Oberbegriff des Anspruchs 1 durch die kennzeichnenden Merkmale des Anspruchs 1 gelöst. Schließlich ist die Aufgabe bei einem Beleuchtungssystem gemäß Oberbegriff des Anspruchs 9 durch das kennzeichnende Merkmal des Anspruchs 9 gelöst.

Ein wesentlicher Effekt der erfindungsgemäßen Lehre liegt in der nunmehr vorhandenen Temperaturstabilität einer einmal eingestellten nichtlinearen, insbesondere logarithmischen oder antilogaritmischen, Übertragungscharakteristik. Gleichzeitig ermöglicht die Erfindung die Analog/Digital- oder die Digital/Analog-Umsetzung eines analogen oder digitalen Eingangssignales mit der vorgenannten Charakteristik. Digitale Führungsgrößen können so auf analoge Führungsgrößen umgesetzt werden und analogen Steuerungen oder Regelungen, welche lineare Charakteristiken haben, als Führungsgröße vorgegeben werden. Auf gleiche Weise ist es gemäß der Erfindung möglich von analogen Führungsgrößen auf digital gesteuerte oder geregelte Systeme überzuwechseln, bei gleichzeitiger Gewährung der logarithmischen bzw. exponentiellen Charakteristik.

Ein weiterer wesentlicher Effekt der Erfindung liegt in dem möglichen Gleichlauf von mehreren parallellen Beleuchtungssystemen, die von einer einzelnen analogen oder digitalen Führungsgröße gesteuert werden. Neben dem verbesserten Abgleich ist auch die Temperaturstabilität ein wesentlicher Faktor zur Erhaltung der zeitlichen Konstanz und des zeitlichen Gleichlaufs unterschiedlicher Beleuchtungssysteme.

Ein Zweck der Erfindung liegt auch in der Einsparung von Analog/Digital- oder Digital/Analog-Umsetzerauflösung. Der diesbezügliche erfinderische Effekt liegt bei gleichem Meßbereich in einer erhöhten Auflösung des empfindlicheren Bereiches. Dies entspricht einer Verdichtung der vorhandenen Digitalworte im geringen unteren Helligkeitsbereich.

Geht man hierbei zunächst von einem linearen System aus, so entspricht eine 10%ige Änderung eines digitalen Steuerwortes beispielsweise einer Änderung der einem Beleuchtungskörper zugeführten Leistung um ebenfalls 10%. Eine 10%ige Führungsgrößenänderung bewirkt so regelmäßig eine 10%ige Leistungsänderung. Dies gilt für den gesamten Leistungs-Steuerbereich. Bei digitalen Führungsgrößen ist der Wertbereich, den ein Führungsgrößensignal überstreichen kann, durch die Anzahl der bits eines digitalen Wortes vorgegeben. Ein Einsatz von beispielsweise 8bit ermöglicht 256 verschiedene unipolare (0...+256) Führungsgrößenwerte. Entsprechend der vorgenannten linearen Übertragungscharakteristik ergeben sich demnach auch 256 mögliche Leistungen und demgemäß 256 mögliche Helligkeitsstufen.

Aufgrund der nichtlinearen Empfindlichkeit des menschlichen Auges wird diese lineare Abhängigkeit jedoch nicht als lineare Helligkeitsveränderung empfunden. Eine 1%-ige Helligkeitsveränderung muß jeweils auf den gerade aktuellen Helligkeitswert (Nennwert) bezogen werden, sie darf nicht auf den maximal möglichen Helligkeitswert bezogen werden. Eine 1%-ige Helligkeitsänderung bei bereits nur 10% der maximal möglichen Helligkeit entspricht somit einer notwendigen 0,1%-igen Helligkeitsveränderung bei einem Zehntel der maximal möglichen Helligkeit. Dies erfordert für geringere Helligkeitswerte eine Veringerung der Helligkeitsabstufung. Dies kann bei linearen Systemen nur durch eine erhöhte Gesamtauflösung, d.h. durch eine Vergrößerung der Bitbreite der verwendeten digitalen Steuerworte, erreicht werden. Neben der Erhöhung der Auflösung in den unteren Helligkeitsbereichen wird bei linearer Charakteristik gleichzeitig auch die Auflösung in den Bereichen höherer Helligkeit, bis hin zur maximalen Helligkeit, erhöht. In den Bereichen höherer Helligkeit ist diese Auflösung jedoch nicht erforderlich, es sei denn eine erhöhte Gesamtabstufung wird angestrebt. Sie birgt vielmehr eine nicht notwendige Aufwands- und Kostenerhöhung. Im vorgenannten Beispiel wäre eine im unteren Helligkeitsbereich notwendige Helligkeitsabstufung zu 0,1% nun auch im oberen Helligkeitsbereich vorhanden. Dort ist sie ohne jede Wirkung.

Gemäß der Erfindung wird nun mit steigender Helligkeit die Leistungsabstufung erhöht. Dies wird im einfachsten Falle durch zwei aneinanderstoßende Geradenabschnitte mit unterschiedlicher Steigung erreicht. Besonders vorteilhaft ist die kontinuierliche Abstufungsveränderung zur Bildung einer näherungsweise exponentiellen oder antilogarithmischen Übertragungsfunktion. Neben dem Einsatz in Steuer- und Regelsystemen kann das erfindungsgemäße Verfahren und die erfindungsgemäße Schaltungsanordnung vorteilhaft auch in Lichtmeßsystemen oder elektronischen Vorschaltgeräten zur Steuerung der Helligkeit von Gasentladungslampen Einsatz finden. Ebenso ist in herkömmlichen Phasenanschnittdimmen mit der Erfindung ein augengerechtes Dimmen möglich.

Angemerkt sei, daß die mathematisch korrekte Exponentialfunktion für einen Abszissenwert 0 einen Ordinatenwert von 1 aufweist. Die Steuer-, Meß- oder Regelcharakteristik von Verfahren und Schaltungsanordnungen gemäß der Erfindung gehen in ihrer Übertragungsfunktion jedoch regelmäßig vom Ursprung aus. Dies entspricht einer vertikalverschobenen näherungsweise exponentiell verlaufenden Übertragungscharakteristik. Spiegelbildlich hierzu ist die Übertragungsfunktion mit logarithmischer Charakteristik horizontal derart verschoben, daß auch sie vom Ursprung ausgeht.

Neben dem vorteilhaften Einsatz von einer eine logarithmische oder antilogarithmische Charakteristik aufweisenden Schaltungsanordnung in einem Steuer- oder Regelsytem können zur Einsparung von Kosten und Senkung der notwendigen digitalen Auflösungen auch zwei der genannten Schaltungsanordnungen vorteilhaft Einsatz finden. Diese sind dann spiegelbildlich anzuordnen, der Analog/Digital-Umsetzer bildet eine logarithmische Funktion eingangsmäßig nach, intern arbeitet das Steuer- oder Regelsystem (mit logarithmischen Größen) linear, die ausgangsseitige Übertragungscharakteristik wird antilogarithmisch oder exponentiell ausgeführt. Auf diese Weise werden systemintern programmtechnisch anfallende Multiplikationen und Divisionen durch einfache Additionen und Subtraktionen möglich. Wirkungsgemäß sind die beiden Schaltungssysteme dann in Reihe geschaltet anzusehen, wobei sich ihre Gesamtwirkung linearisiert.

Vorteilhafte Ausgestaltungen der erfindungsgemäßen Schaltungsanordnung sind in den Unteransprüchen angegeben. Dieses betrifft insbesondere die Aufschaltung des halben analogen Eingangssignales (bei einem Analog/Digital-Umsetzer) oder des halben analogen Ausgangssignales (bei einem Digital/Analog-Umsetzer) auf den jeweiligen Referenzeingang des jeweiligen Umsetzers. Hierbei wird in besonders vorteilhafter Weise die größtmögliche Annäherung an die menschliche Sehcharakteristik erzielt.

Digital/Analog-Umsetzer und Analog/Digital-Umsetzer können als Referenzsignale sowohl Spannungen als auch Ströme erhalten. Gleiches gilt für die analogen Eingangs- und Ausgangsgrößen.

Die Erfindung wird nachfolgend anhand von Ausführungsbeispielen näher erläutert. Es zeigen

Fig.1 ein Beispiel eines Analog/Digital-Umsetzers (ADU) mit näherungweiser logarithmischer Übertragungsfunktion zwischen analoger Eingangsgröße und digitalem Datenwort ,

Fig.2 ein Ausführungsbeispiel der Erfingung als Digital/Analog-Umsetzer mit einer näherungweise exponentiellen Übertragungscharakteristik zwischen digitalen Eingangsdaten und analoger Ausgangsgröße

Fig.3 eine lineare abgestufte Übertragungscharakteristik eines handelsüblichen ADU oder DAU, mit erfindungsgemäß möglichen Kennlinien,

Fig.4 ein Detailschaltbild der in den Figuren 1 und 2 zur Kombination von analogem Ein- bzw. Ausgangssignal zum Referenzsignal der jeweiligen Wandler verwendeten Schaltungsanordnung.

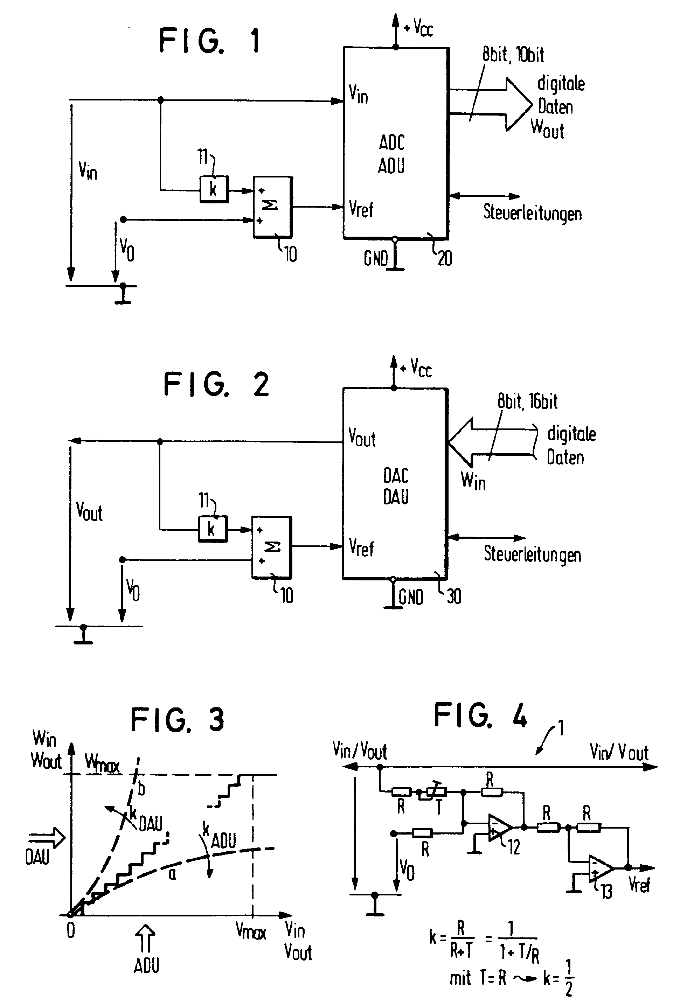

Fig.1 zeigt einen handelsüblichen ADU 20, dem ein analoges Referenzsignal $V_{ref}$ und ein analoges Eingangssignal $V_{in}$ zuführbar ist. Der ADU 20 ist an eine positive Versorgungsspannung $V_{cc}$ und eine Masse GND angeschlossen. An seinem Ausgang gibt der ADU 20 digitale Datenworte $W_{out}$ einer vorgegebenen Bitbreite, beispielsweise 8bit, 10bit, oder 12bit, ab. Diese Datenworte $W_{out}$ entsprechen in digitaler Darstellung dem analogen Eingangssignal $V_{in}$ unter Berücksichtigung des zur digitalen Umsetzung herangezogenen Referenzsignales $V_{ref}$. Der ADU weist ferner Steueranschlüsse auf, mittels welcher unter anderem Analog/Digital-Umsetzungen eingeleitet werden, digitale Ausgangstreiber ein- und abgeschaltet werden oder sonstige Informationen dem ADU mitgeteilt werden. Der Referenz-Eingangsanschluß $V_{ref}$ ist mit Ausgangsanschluß eines analogen Summiergliedes 10 verbunden. Das Summierglied 10 weist zwei Analogeingänge auf, dem einen ist eine Bezugsspannung $V_0$ oder ein entsprechender Bezugsstrom $I_0$ zugeführt, dem anderen ist das analoge Eingangssignal $V_{in}$ über ein Proportionalglied 11 mit der Verstärkung k zugeführt. Das Summierglied 10 kann, wie erwähnt, entweder Ströme oder Spannungen summieren. Ebenso kann es Referenzströme oder Referenzspannungen an den ADU-Referenzeingang $V_{ref}$ abgeben. Dies hängt von einem jeweiligen ADU-Typ ab.

Das analoge Eingangssignal $V_{in}$, welches ein Führungsgrößen- oder Meßsignal sein kann, steuert nun zum einen den Analogeingang des ADU 20 und über das Proportionalglied 11 den analogen Summierverstärker 10. Dieser gibt an seinem Ausgangsanschluß die Summe aus gewichtetem analogen Eingangssignal $k*V_{in}$ und Bezugssignal $V_0$ ab. Gemäß der ADU-eigenen linearen Übertragungscharakteristik,

$$W_{out} = W_{max} * V_{in}/V_0 \quad (1),$$

wird auf Anforderung zur A/D-Umsetzung über eine der Steuerleitungen das analoge Eingangssignal $V_{in}$ in eine entsprechende digitale Ausgangsdarstellung $W_{out}$ umgesetzt. Der maximale digitale Wert $W_{max}$ hängt von der Auflösung des ADU ab. Er wird durch die Bitbreite des Wortes bestimmt, bei 8bit beträgt $W_{max}=256$ bei 10bit beträgt $W_{max}=1024$. Dies gilt für unipolare Eingangssignale $V_{in}0$. Wenn ein symmetrisch bipolares Eingangssignal verwendet werden soll, halbiert sich die jeweilige maximale Ausgangsamplitude, da positive und negative analoge Größen digital repräsentiert werden müssen.

Ein linearer ADU weist den Proportionalfaktor k=0 auf, mithin ist das Referenzsignal $V_{ref}=V_0$. Dies entspricht einem unveränderlichen und konstanten, insbesondere temperaturkonstanten Referenzwert. Der analoge Eingangswert $V_{in}$ wird innerhalb der Grenze $0 \leqq V_{in} \leqq V_{ref}$ linearstufig in ein digitales entsprechendes Wort $W_{out}$ umgesetzt. Wenn k>0 gewählt wird, entsteht eine veränderliche von dem Eingangssignal $V_{in}$ abhängige Referenzspannung $V_{ref}$. Sie ist abhängig - von der Größe von k - stärker oder weniger stark vom Eingangssignal abhängig.

$$W_{out} = V_{in}/(V_{ref} + k * V_{in}) \quad (2)$$

bestimmt nunmehr die Umsetzung von analoger Größe $V_{in}$ auf digitale Darstellung $W_{out}$. Diese Übertragungscharakteristik oder Übertragungsfunktion ist nichtlinear. Wählt man nun den Faktor k des Proportionalgliedes 11 zu k=0.5, so kann als Übertragungscharakteristik eine gute Näherung an einen Abschnitt einer Logarithmus-Funktion gewonnen werden.

Dies sei im folgenden anhand der Taylor-Potenzreinentwicklung für den natürlichen Logarithmus ln(x) gezeigt:

$$0.5 * \ln(x) = \frac{x-1}{x+1} + \frac{1}{3}\left(\frac{x-1}{x+1}\right)^3 + \frac{1}{5}\left(\frac{x-1}{x+1}\right)^5 + \dots \quad (3).$$

Sie stellt die Reihenentwicklung des natürlichen Logarithmus dar, sie konvergiert für x>0.

Eine Verschiebung in horizontaler Richtung

$$x' \text{ ersetzt } x + 1 \quad (4),$$

ergibt eine verschobene Logarithmusfunktion gemäß der folgenen Gleichung ab $x^5$ vernachlässigt),

$$\ln(x+1) = \frac{x}{1+0.5x} + \frac{2}{3}\left(\frac{x}{1+0.5x}\right)^3 \quad (5).$$

Für x<1 wird der kubische Ausdruck gegenüber dem linearen Anteil bereits vernachlässigbar. Der erste Term von (5) entspricht dann (2), womit die Übertragungsfunktion des mit Proportionalglied 11 und Summierverstärker 10 beschalteten ADU 20 näherungsweise eine verschobene logarithmische Funktion ergibt.

Für andere Werte von k können logarithmische Funktionen mit veränderter Steigung oder andere nichtlineare Übertragungsfunktionen angenähert werden. Zu beachten ist bei Dimensionierung von k lediglich der Maximalwert der Referenzspannung $V_{ref}$. Dieser darf bei maximaler Eingangsspannung $V_{in}$ und vorgegebener Bezugsspannung $V_0$ nicht überschritten werden. Hierbei kann sowohl die Bezugsspannung $V_0$ als auch der Proportionalfaktor k in weiten Grenzen variiert werden.

Auf gleiche Weise läßt sich die anhand von Fig.1 beschriebene Nachbildung einer logarithmischen Übertragungsfunktion "spiegeln" zur Bildung einer antilogaritmischen oder exponentiellen Übertragungscharakteristik eines Digital/Analog-Umsetzers (DAU) 30 gemäß Fig.2. Der DAU 30 weist hierbei ebenfalls einen Referenzeingang $V_{ref}$ und die bereits anhand von Fig.1 erläuterten Steuer- und Status-Ein- und -Ausgänge auf. In Fig.2 ist lediglich die Richtung des informationvermittelnden Datenflusses invertiert. Der DAU wird mit digitalen Daten gespeist und gibt ein analoges Ausgangssignal $V_{out}$ ab. Dieses ist wiederum über ein Proportionalglied 11 und einen Summiervertärker 10 dem Referenzeingang $V_{ref}$ zugeführt. Dem Summierverstärker 10 wird, wie in Fig.1 erläutert eine Bezugsspannung $V_0$ als zweites Eingangssignal zugeführt. Er bildet wiederum die Summe aus seinen beiden Eingangssignalen. Der DAU 30 weist eine gegenüber dem ADU 20 veränderte zunächst lineare Übertragungscharakteristik auf. Hier gilt

$$V_{out} = V_{ref} * W_{in}/(W_{max} + 1) \text{ oder } V_{out} =$$
$$V_{ref} * W_{in}/W_{max} \quad 6)$$

Die digitalen Eingangsdaten $W_{in}$ werden gemäß (6) in eine analoge Ausgangsgröße $V_{out}$ umgesetzt. $W_{max}$ entspricht, wie bereits in Fig.1 erwähnt, dem maximalen digitalen Datenwort. Für k=0 wird eine lineare Übertragungscharakteristik erhalten, jedes digitale Eingangssignal $W_{in}$ wird entsprechend einer linearen Übertragungscharakteristik (wie sie in Fig.3 dargestellt ist) umgesetzt. Eine anteilige Kopplung des analogen Ausgangssignales zurück auf den Referenzeingang $V_{ref}$ steigert mit steigendem analogen Ausgangssignal die Wirkung jedes hinzukommenden digitalen Bits. Dies entspricht einer exponentiellen Übertragungscharakteristik.

$$V_{out} = (V_0 + k * V_{out}) * W_{in}/(W_{max} + 1) \quad (7).$$

Für k=0.5 ergibt sich spiegelbildlich zu der zuvor anhand (3,4,5) dargelegten Potenzreihenentwicklung nun eine näherungsweise exponentielle Übertragungscharakteristik. Diese ist entsprechend der Horizontalverschiebung von (4) spiegelbildlich nunmehr vertikal verschoben.

Für steigendes k wird die von dem DAU 30 gebildete Übertragungsfunktion steiler. Für k gegen 0 nähert sich die Übertragungscharakteristik der linearen Übertragungsfunktion von (6) an. Eine solche lineare Übertragungscharakteristik ist stufenartig in Fig.3 dargestellt.

Fig.3 zeigt hierbei abhängig davon, ob ein digitales Eingangssignal oder analoges Eingangssignal gewählt wird, die idealisierte Übertragungsfunktion eines ADU 20 (analoges Eingangssignal auf der Abszisse) oder des DAU 30 (digitales Eingangssignal $W_{in}$ auf der Ordinate). Abhängig von der gewählten Art des Eingangssignales kann auf der jeweils anderen Achse die entsprechende digitale oder analoge Darstellung der Größe abgelesen werden. Mit gestrichelten Linien sind zwei Funktionen a) und b) eingezeichnet, die den Übertragungsfunktionen entsprechen, wie sie mit Schaltung gemäß Fig.1 oder Fig.2 erzielt werden können. a) stellt hierbei die näherungsweise logarithmische Funktion des ADU 20 mit Summierverstärker 10 und Proportionalglied 11 dar. Wenn $k_{ADU}$ steigt, wird die Übertragungscharakteristik gemäß der eingezeichneten Pfeilrichtung weiter abgeflacht.

Auf gleiche Weise stellt die Übertragungscharakteristik b) die näherungsweise exponentielle Übertragungscharakteristik des DAU 30 von Fig.2 mit demselben Summierverstärker 10 und Proportionalglied 11 dar. Für steigendes $k_{DAU}$ wird die eingezeichnete exponentielle Übertragungscharakteristik steiler. Beide Funktionen a) und b) nähern sich für k=0 der idealen linearen und treppenförmigen Umsetzerkennlinie an.

k=0.5 ergibt für beide Anwendungen gemäß Fig.1 und Fig.2 eine für Beleuchtungs- Meß- Steuer- und Regelzwecke besonders vorteilhafte Übertragungscharakteristik (Übertragungsfunktion). Werden in einem solchen System sowohl eine analog/digitale Eingangstransformation gemäß Fig.1 als auch die digital/analoge Ausgangstransformation gemäß Fig.2 eingesetzt, so sollten die jeweiligen Werte von k der Eingangs-und Ausgangstransformation im wesentlichen gleich groß sein. Hierbei sind die beiden Kennlinien a) und b) dann spiegelsymmetrisch.

Beide Übertragungscharakteristiken, die der Fig.1 und die der Fig.2 bzw. die Funktion a) und b) in Fig.3, beginnen im Ursprung. Dies entspricht der gemäß (4) erwähnten Horizontalverschiebung einer näherungsweise logarithmischen Funktion und der Vertikalverschiebung einer näherungsweise exponentiellen Funktion. Beide Funktionen beginnen im Ursprung, näherungsweise mit einer Steigung von 45°. Möchte man die Anfangssteigung nun verändern, so kann man diese über die Wahl der Bezugsspannung $V_0$ oder über eine unterschiedliche Gewichtung $k_0$ eines vorgegebenen $V_0$ (Anteil von $V_0$) erreichen. Eine Reduzierung des Wertes $V_0$ oder des Teils von $V_0$ gegenüber dem für den ADU 20 vorgegebenen (Datenblatten) Wert erhöht die anfängliche Steigung (im Ursprung) der Funktion a) von Fig.3 für die Schaltungsanordnung gemäß Fig.1. Auf gleiche Weise senkt eine gegenüber dem Datenblattwert des DAU 30 reduzierte Bezugsspannung $V_0$ oder eine reduzierte Gewichtung in dem Summierverstärker 10 die anfängliche Steigung der Funktion b) von Fig.3.

Durch angepaßtes Zusammenspiel zwischen mit $k_0$ reduzierter/erhöhter Bezugsspannung $V_0$ der über das Proportionalglied 11 (den Proportionalfaktor k) gewichteten analogen Eingangsspannung $V_{in}$ kann sowohl die anfängliche Steigung der näherungsweise logarithmischen Funktion a) als auch ihr maximaler Endwert eingestellt werden. Auf diese Weise wird es möglich, für den maximalen analogen Eingangswert $V_{max}$ gerade das maximale digitale Ausgangswort $W_{max}$ bei näherungsweise logarithmischer Charakteristik zu erreichen. Beträgt die maximale Eingangsspannung $V_{in}=V_{max}$ und beträgt die Nenn-Referenzspannung $V_{ref}=OV$, so bestimmt sich der vorteilhaft reduzierte Bezugsspannungs-Faktor $k_0$ gemäß der folgenden Gleichung

$$k * V_{max} + k_0 * V_0 = V_{ref0} \quad (8).$$

$V_{ref}0$ bildet den Nennwert (Datenblattwert) der Referenzspannung $V_{ref}$.

Das Zuvorgesagte gilt gleichsam auch für die Schaltungsanordnung gemäß Fig.2, hierbei ist die Funktion b) von Fig.3 betroffen, deren anfängliche Steigung im Ursprung gegenüber der linearen Übertragungscharakteristik gesenkt wird, wobei gleichzeitig der für maximales digitales Datenwort $W_{in}=W_{max}$ am Ausgang des DAU 30 erscheinende Analogwert $V_{out}$ dem Nenn- oder Maximalwert $V_{max}$ entspricht. In beiden zuletzt genannten Fällen geht somit keine Auflösung verloren, $W_{max}$ oder $V_{max}$ wird in beiden Fällen erreicht.

Schließlich zeigt Fig.4 ein Schaltungsbeispiel für das Proportionalglied 11 und den Summierverstärker 10, welche die bedingt veränderliche Referenzspannung $V_{ref}$ erzeugt. Das analoge Ein- oder Ausgangssignal steuert über eine Reihenschaltung eines Widerstandes R und eines Potentiometers T den invertierenden Eingang eines Operationsverstärkers 12. Dem invertierenden Eingang wird ferner ein Strom $I_0=V_0/R$ zugeführt. Der Ausgangsanschluß des Operationsverstärkers 12 ist über einen weiteren Widerstand R mit dem invertierenden Eingangsanschluß verbunden. Am Ausgang des so geschalteten invertierenden Summierverstärkers erscheint die Summe aus Bezugsspannung $V_0$ und der gewichteten analogen Ein- oder Ausgangsspannung. Für R=T entsteht der zuvor als besonders vorteilhaft bezeichnete Proportionalfaktor k=0.5. Für den Fall, daß ein invertiertes Spannungssignal am Ausgang von Operationsverstärker 12 dem ADU oder dem DAU 30 in positiver Spannungsform oder Stromform zugeführt werden muß, kann ein weiterer Operationsverstärker 13 nachgeschaltet werden. Dieser ist mit zwei Widerständen R als Eingangs- und Rückführungswiderstand so geschaltet, daß er die Verstärkung -1 aufweist. Sein Ausgangsanschluß steuert entweder direkt oder über einen weiteren stromeinprägenden Widerstand den Referenzspannungseingang $V_{ref}$ oder Referenzstromeingang $I_{ref}$ des ADU 20 oder des DAU 30. Vorteilhaft kann weiterhin eine Glättung des Referenzspannungssignales $V_{ref}$ oder des Referenzstromsignales $I_{ref}$ vorgesehen werden. Dies verschleift mögliche Sprungstellen in der Übertragungsfunktion des beschalteten nichtlinearen ADU 20 oder DAU 30. Eine Glättung kann durch einen zum Rückführwiderstand R des Operationsverstärkers 13 parallelgeschalteten Glättungskondensator erfolgen; dieser Glättungskondensator ist auch parallel zu dem Rückführwiderstand R des Operationsverstärkers 12 schaltbar.

Eine weitere, nur den veränderlichen Anteil des Referenzspannungssignales $V_{ref}$ glättende, vorteilhafte Variante bietet sich durch ein T-Filter am Eingang des Operationsverstärkers. Hierbei wird der Glättungskondensator mit seinem einen Eingangsanschluß zwischen den Widerstand R und das Potentiometer T geschaltet, welche Reihenschaltung die Verbindung zwischen analogem Ein- oder Ausgangssignal $V_{in}$,$V_{out}$ und invertierendem Eingangsanschluß des Operationsverstärkers 12 bildet. Sein anderer Ausgangsanschluß wird gegen Masse geschaltet.

In einem Beleuchtungssystem, in welchem eine Leistungsregelung mittels eines elektronischen Vorschaltgerätes (EVG) ausgeführt wird, ist sowohl die Schaltungsanordnung gemäß Fig.1 als auch eine solche gem.Fig.2 vorteilhaft einsetzbar. Die in dem EVG durchgeführte Leistungsregelung bezieht sich auf die an einen Leuchtkörper (Gasentladungslampe) abgegebene Leistung. Diese wird bei üblichen Lampen-Lastkreisen, die Serienresonanzkreise aufweisen, durch Frequenzvariation der von dem EVG abgegebenen Ausgangs-Wechselspannung erzielt. Eine Leistungsregelung setzt ein Soll-Istwertvergleich voraus. Dieser wird mit einer vorgegebenen Soll-Leistung $P_{soll}$ und dem an den Lampen- oder dem EVG gemessenen Leistungs-Istwert $P_{ist}$ durchgeführt. Werden vollständig lineare Verhältnisse vorausgesetzt, d.h. das EVG weist eine lineare Steuercharakteristik auf, so kann in linearer Abhängigkeit von der vorgegebenen Soll-Leistung eine linear Ist-Leistung an die Lampen abgegeben werden. Dies entspricht nicht dem menschlichen Helligkeitsempfinden.

Daher kann in den Sollwertkanal vorteilhaft eine Schaltungsanordnung gemäß Fig.2 eingefügt werden. Diese weist eine näherungsweise exponentielle Kennlinie auf, womit ein augengerechtes - dem menschlichen Sinnesempfinden angemessenes - Ändern der Helligkeit erreicht wird. Hierbei kann der Sollwert digital vorgegeben werden, es entsteht nach dem DAU 30 von Fig.2 eine analoge Führungsgröße die nunmehr dem analogen Leistungsregelkreis mit EVG vorgegeben wird. Vorteilhaft ist, daß ein digitaler Sollwert einsetzbar ist und der üblicherweie analoge Regelkreis auf der Basis eines analogen Soll-Istwertsvergleiches ($P_{soll}$-$P_{ist}$) arbeitet. Dies ist besonders praxisfreundlich, da die gemessene Leistung üblicherweise als analoge Größe $P_{ist}$ vorliegt.

Eine weitere vorteilhafte Variante - unter Einsatz der Schaltungsanordnung gem. Fig.2 - bietet sich bei einem digitalen Soll-Istwertvergleich an. In diesem Fall wird ein digitaler Sollwert $P_{soll}$ vorgegeben, von diesem wird ein digitaler Istwert $P_{ist}$ subtrahiert. Die nunmehr digital vorliegende Differenz steuert das EVG und den in dem EVG vorgesehenen Wechselrichter. Dies ist dann besonders vorteilhaft, wenn der Wechselrichter fremdgeführt ist und seine Ausgangsfrequenz über einen digital einstellbaren VCO (voltage controlled oszillator) oder einen über digitalen Zähler gesteuerten Frequenzgenerator vorgebbar ist.

Die ebenfalls gemessene analoge Leistungs-Istgröße wird über einen ADU 20 mit der Beschaltung aus Summierglied 10 und Proportionalglied 11 in einen digitalen Meßwert $P_{ist}$ umgesetzt. Dieser Meß-

wert weist so die näherungsweise logarithmische Kennlinie auf. Das augengerechte Helligkeitsändern wird alternativ zu der vorhergehenden Variante durch Beeinflussung des Istwertkanales erreicht.

Die zuvor erläuterte regelungstechnischen Schaltungsanordnungen bilden vorteilhafte Ausgestaltungen, Änderungen im Rahmen rein regelungstechnischer Umformung der entstehenden Blockschaltbilder sind möglich, so daß diese im Einzelnen nicht weiter erläutert werden sollen.

**Patentansprüche**

1. Schaltungsanordnung zum Annähern einer logarithmischen oder antilogarithmischen Übertragungsfunktion zur Digital-Analog-Wandlung/Umsetzung eines digitalen Eingangssignales ($W_{in}$) mit näherungsweiser logarithmischer oder antilogarithmischer Übertragungsscharakteristik, **dadurch gekennzeichnet,** daß eine analoge Reverenzgröße ($V_{ref}$) und ein digitales/binäres Eingangssignal ($W_{in}$) einem Digital-Analog-Wandler (DAW, DAU, 30) zuführbar ist, daß der Wandler (30) ein analoges Ausgangssignal ($V_{out}$) auf der Basis einer im wesentlichen linearen Umsetzer-/Wandlercharakteristik erzeugt, daß dem linearen Wandler (30) eine nichtkonstante, von dem analogen Ausgangssignal ($V_{out}$) abhängige Referenzgröße ($V_{ref}$) vorgebbar ist, und daß eine von dem analogen Ausgangssignal ($V_{out}$) gesteuerte Verstärkerschaltung vorgesehen ist, deren Ausgangsspannung ($V_{out}$) sowohl das analoge Ausgangssignal ($V_{out}$) der Schaltungsanordnung (10,11,20) als auch das zur analogen Kopplung auf die Reverenzgröße ($V_{ref}$) bestimmte Rückkopplungssignal bildet.

2. Schaltungsanordnung nach Anspruch 1, **dadurch gekennzeichnet,** daß die nichtkonstante Referenzgröße ($V_{ref}$) einen ersten Anteil einer im Betrieb der Schaltungsanordnung unveranderlichen Bezugsgröße ($V_o$) und einen im Betrieb der Schaltungsanordnung zweiten Anteil (k) des veränderlichen Ausgangssignales ($V_{out}$) des Wandlers (30) enthält.

3. Schaltungsanordnung nach Anspruch 2, **dadurch gekennzeichnet,** daß der erste Anteil im wesentlichen eins ist und der zweite Anteil (k) im wesentlichen 0.5 berägt, wobei eine im wesentlichen logarithmische oder antilogarithmische Übertragungsfünktionscharkteristik der Schaltungsanordnung (10,11,30) gebildet wird.

4. Schaltungsanordnung nach einem der vorherstehenden Ansprüche, **dadurch gekennzeichnet,** daß eine Summierschaltungsanordnung (10,11, 12,13;1) vorgesehen ist, welche die analoge Referenzgröße ($V_{ref}$) an den Wandler (30) abgibt, während ihr (1) sowohl das in seiner Eingangsamplitude über einen ersten Festwiderstand (R) und einen einstellbaren Widerstand (T) herabgesetzte analoge Ausgangssignal ($V_{out}$) als auch über einen weiteren Festwiderstand (R) die unveränderliche Bezugsgröße ($V_o$) zugeführt wird.

5. Schaltungsanordnung nach Anspruch 4, **dadurch gekennzeichnet,** daß die Summierschaltungsanordnung (1) einen ersten Summierverstärker/Operationsverstärker (12) zur Strom- oder Spannungssummation des ersten und des zweiten Anteils der Referenzgröße ($V_{ref}$) aufweist, und daß abhängig von dem für den Wandler (30) erforderlichen Vorzeichen der Referenegröße ($V_{ref}$) dem ersten Verstärker (12) ein invertierender zweiter Verstärker (13), vorzugsweise mit der Verstärkung -1, nachgeschaltet ist, wobei entweder der erste Verstärker (12) oder der zweite Verstärker (13) ein Spannungs- oder Stromsignal als analoge Referenzgröße ($V_{ref}$) an den Wandler (30) abgibt.

6. Schaltungsanordnung nach Anspruch 4 oder 5, **dadurch gekennzeichnet,** daß der Widerstandswert des einstellbaren Widerstandes (T) im wesentlichen dem Widerstandswert der gleichwertigen ersten und zweiten Festwiderstandes (R) entspricht oder der einstellbare Widerstand (T) durch einen dritten gleichwertigen Festwiderstand (R) gebildet ist.

7. Schaltungsanordnung nach Anspruch 4, **dadurch gekennzeichnet,** daß das analoge Ausgangssignal ($V_{out}$) des Wandlers (30) durch einen Ausgangsstrom gebildet ist, und daß die Verstärkerschaltung als Strom-Spannungswandler geschaltet ist.

8. Schaltungsanordnung nach Anspruch 4, **dadurch gekennzeichnet,** daß die Summierschaltung (1), bei einem Digital-Analog-Wandler (30), dessen analoges Ausgangssignal ($V_{out}$) durch einen Ausgangsstrom gebildet wird, einen ersten als Strom-Spannungswandler geschalteten Verstärker (12) und einen diesem nachgeschalteten, als Summierverstärker für einen Anteil des Ausgangssignales des ersten Verstärkers (12) und für die Bezugsgröße ($V_o$) oder für einen Anteil der Bezugsgröße ($V_o$) vorgesehe-

nen zweiten Verstärker (13) aufweist,
wobei die die Anteile bestimmenden Verstärkungsfaktoren durch Festwiderstände (R) und/oder einstellbare Widerstände (T) so gewählt werden, daß die gesamte Schaltungsanordnung (10,11, 30) näherungsweise eine exponentielle Abhängigkeit zwischen dem digitalen Eingangssignal ($W_{in}$) und der vom ersten Verstärker (12) abgegebenen analogen Ausgangsspannung ($V_{out}$) vorgibt.

9.  Beleuchtungssystem, bei welchem die Helligkeit ($P_{ist}$) einer oder mehrerer Lichterzeuger, insbesondere einer oder mehrerer Gasentladungslampe(n), abhängig von einer Helligkeits- oder Leistungs-Sollgröße ($P_{soll}$) gesteuert oder geregelt wird,
    **dadurch gekennzeichnet,**
    daß die Helligkeits-Soflgröße ($P_{soll}$) oder die -Istgröße ($P_{ist}$) über eine Schaltungsanordnung gemäß Anspruch 1 geführt ist.

10. Beleuchtungssystem nach Anspruch 9,
    **dadurch gekennzeichnet,**
    daß bei einer Leistungsregelung entweder die Leistungs-Sollgröße ($P_{soll}$) nichtlinear, insbesondere exponentiell, in ihrer Linearität verändert wird, oder daß die Leistungs-Istgröße ($P_{ist}$) in ihrer Linearität, insbesondere logarithmisch, verändert wird.

**Claims**

1.  Circuitry arrangement for approximating a logarithmic or anti-logarithmic transformation function for digital-analog conversion/translation of a digital input signal ($W_{in}$) with approximately logarithmic or anti-logarithmic transformation characteristic,
        characterized in that,
        an analog reference quantity ($V_{ref}$) and a digital/binary input signal ($W_{in}$) can be supplied to a digital-analog converter (DAW, DAU, 30),
            in that,
        the converter (30) generates an analog output signal ($V_{out}$) on the basis of a substantially linear translation/conversion characteristic,
            in that,
        a non-constant reference quantity ($V_{ref}$), dependent upon the analog output signal ($V_{out}$), can be provided to the linear converter (30),
            and in that,
        there is provided an amplifier circuit, controlled by the analog output signal ($V_{out}$), the output voltage ($V_{out}$) of which provides both the analog output signal ($V_{out}$) of the circuitry arrangement (10, 11, 20) and the feedback signal for analog coupling to the reference quantity ($V_{ref}$).

2.  Circuitry arrangement according to claim 1,
        characterized in that,
        the non-constant reference quantity ($V_{ref}$) comprises a first component of a reference quantity ($V_0$) which is non-variable in operation of the circuitry arrangement, and a, in operation of the circuitry arrangement, second component (k) of the variable output signal ($V_{out}$) of the converter (30).

3.  Circuitry arrangement according to claim 2,
        characterized in that,
        the first component is substantially unity and the second component (k) is substantially 0.5, whereby a substantially logarithmic or anti-logarithmic transformation function characteristic of the circuitry arrangement (10, 11, 30) is formed.

4.  Circuitry arrangement according to any preceding claim,
        characterized in that,
        a summation circuitry arrangement (10, 11, 12, 13; 1) is provided, which provides the analog reference quantity ($V_{ref}$) to the converter (30), whilst there are supplied thereto (1) both the analog output signal ($V_{out}$), reduced in its amplitude by means of a first fixed resistance (R) and a settable resistance (T) , and - via a further fixed resistance (R) - the non-variable reference quantity ($V_0$).

5.  Circuitry arrangement according to claim 4,
        characterized in that,
        the summation circuitry arrangement (1) has a first summing amplifier/operational amplifier (12) for current or voltage summation of the first and second components of the reference quantity ($V_{ref}$),
            and in that,
        in dependence upon the sign of the reference quantity ($V_{ref}$) necessary for the converter (30), there is connected after the first amplifier (12) an inverting second amplifier (30), preferably with the amplification factor -1, whereby either the first amplifier (12) or the second amplifier (30) provides a voltage or current signal as analog reference quantity ($V_{ref}$) to the converter (30).

6.  Circuitry arrangement according to claim 4 or 5,
        characterized in that,
        the resistance value of the settable resistance (T) corresponds in substance to the resistance value of the like-valued first and second fixed resistances (R) or the settable resistance (T) is formed by a third like-valued fixed resistance (R).

**7.** Circuitry arrangement according to claim 4,
characterized in that,
the analog output signal ($V_{out}$) of the converter (30) is formed by an output current, and in that the amplifier circuit is connected as current-voltage converter.

**8.** Circuitry arrangement according to claim 4,
characterized in that,
in the case of a digital-analog converter (30) the analog output signal ($V_{out}$) of which is formed by an output current, the summation circuitry (1) has a first amplifier (12), connected as a current-voltage converter, and a second amplifier (13), connected after the first amplifier, provided as summation amplifier for a component of the output signal of the first amplifier (12) and for the reference quantity ($V_0$) or for a proportion of the reference quantity ($V_0$),
whereby the amplification factors which determine the components are so selected, by means of fixed resistances (R) and/or settable resistances (T) that the overall circuitry arrangement (10, 11, 30) approximately provides an exponential dependence between the digital input signal ($W_{in}$) and the analog output voltage ($V_{out}$) delivered from the first amplifier (12).

**9.** Lighting system, in which the brightness ($P_{ist}$) of one or more light producers, in particular of one or more gas discharge lamps, is controlled or regulated in dependence upon a desired-value parameter ($P_{soll}$) of brightness or power,
characterized in that,
the brightness desired-value parameter ($P_{soll}$) or the actual-value parameter ($P_{ist}$) is supplied via a circuitry arrangement according to claim 1.

**10.** Lighting system according to claim 9,
characterized in that,
in the case of power regulation either the power desired-value parameter ($P_{soll}$) is non-linearly, in particular exponentially, varied in its linearity, or the power actual-value parameter ($P_{ist}$) is varied in its linearity, in particular logarithmically.

## Revendications

**1.** Circuit d'approximation d'une fonction de transfert logarithmique ou antilogarithmique pour la conversion numérique-analogique d'un signal d'entrée ($W_{in}$) avec une caractéristique de transfert approximativement logarithmique ou antilogarithmique,
caractérisé par le fait
qu'une grandeur de référence ($V_{ref}$) analogique et un signal d'entrée ($W_{in}$) numérique/binaire sont appliqués à un convertisseur numérique-analogique (DAW, DAU, 30),
que le convertisseur (30) produit un signal de sortie ($V_{out}$) analogique sur la base d'une caractéristique de convertisseur sensiblement linéaire,
qu'une grandeur de référence ($V_{ref}$) non constante, dépendant du signal de sortie ($V_{out}$) analogique, est appliquée au convertisseur (30) linéaire, et qu'il est prévu un montage amplificateur qui est commandé par le signal de sortie ($V_{out}$) analogique et dont la tension de sortie ($V_{out}$) forme aussi bien le signal de sortie ($V_{out}$) analogique du circuit (10,11,20) que le signal de réaction destiné au couplage analogique sur la grandeur de référence ($V_{ref}$).

**2.** Circuit suivant la revendication 1,
caractérisé par le fait
que la grandeur de référence ($V_{ref}$) non constante contient une première partie d'une grandeur de comparaison ($V_0$) invariable pendant le fonctionnement du circuit et une deuxième partie (k) du signal de sortie ($V_{out}$) du convertisseur (30), variable pendant le fonctionnement du circuit.

**3.** Circuit suivant la revendication 2,
caractérisé par le fait
que la première partie est sensiblement égale à 1 et la deuxième partie (k) est sensiblement égale à 0,5, ce qui donne une caractéristique de fonction de transfert sensiblement logarithmique ou antilogarithmique du circuit (10,11,30).

**4.** Circuit suivant l'une des revendications précédentes,
caractérisé par le fait
qu'il est prévu un montage de sommation (10,11,12,13;1) qui fournit la grandeur de référence ($V_{ref}$) analogique pour le convertisseur (30), montage (1) auquel sont amenés aussi bien le signal de sortie ($V_{out}$) analogique réduit quant à son amplitude d'entrée, en passant par une première résistance fixe (R) et une résistance réglable (T), que la grandeur de comparaison ($V_0$) invariable, en passant par une autre résistance fixe (R).

**5.** Circuit suivant la revendication 4,
caractérisé par le fait
que le montage de sommation (1) présente un premier amplificateur de sommation/amplificateur opérationnel (12) en vue de la sommation en courant ou en tension de la première partie et de la deuxième partie de la grandeur de référence

(V<sub>ref</sub>), et

qu'en fonction du signe que la grandeur de référence ($V_{ref}$) doit présenter pour le convertisseur (30), le premier amplificateur (12) est suivi d'un deuxième amplificateur (13) à inversion, en particulier à gain -1, soit le premier amplificateur (12), soit le deuxième amplificateur (13) fournissant au convertisseur (30) un signal de tension ou de courant en tant que grandeur de référence ($V_{ref}$) analogique.

6. Circuit suivant la revendication 4 ou 5,
caractérisé par le fait
que la valeur de la résistance réglable (T) correspond sensiblement à la valeur des première et deuxième résistances fixes (R) équivalentes ou que la résistance réglable (T) est formée par une troisième résistance fixe (R) équivalente.

7. Circuit suivant la revendication 4,
caractérisé par le fait
que le signal de sortie ($V_{out}$) analogique du convertisseur (30) est formé par un courant de sortie et que le montage amplificateur est branché en convertisseur courant-tension.

8. Circuit suivant la revendication 4,
caractérisé par le fait
que le montage de sommation (1), dans le cas d'un convertisseur numérique-analogique (30) dont le signal de sortie ($V_{out}$) analogique est formé par un courant de sortie, présente un premier amplificateur (12) branché en convertisseur courant-tension et un deuxième amplificateur (13) faisant suite au premier et prévu comme amplificateur de sommation pour une partie du signal de sortie du premier amplificateur (12) et pour la grandeur de comparaison ($V_0$) ou pour une partie de la grandeur de comparaison ($V_0$),
les facteurs de gain déterminant les parties étant choisis, par le biais de résistances fixes (R) et/ou de résistances réglables (T), de telle manière que le circuit (10,11,30) dans son ensemble détermine approximativement une relation exponentielle entre le signal d'entrée ($W_{in}$) numérique et la tension de sortie ($V_{out}$) analogique fournie par le premier amplificateur (12).

9. Système d'éclairage dans lequel l'intensité lumineuse ($P_{ist}$) d'une ou de plusieurs sources lumineuses, en particulier d'une ou de plusieurs lampes à décharge dans un gaz, est commandée ou régulée en fonction d'une grandeur de consigne ($P_{soll}$) d'intensité lumineuse ou de puissance,
caractérisé par le fait
que la grandeur de consigne ($P_{soll}$) ou la grandeur réelle ($P_{ist}$) d'intensité lumineuse passe par un circuit suivant la revendication 1.

10. Système d'éclairage suivant la revendication 9,
caractérisé par le fait
que dans le cas d'une régulation de puissance, soit la grandeur de consigne ($P_{soll}$) de puissance est modifiée de façon non linéaire, en particulier de façon exponentielle, dans sa linéarité, soit la grandeur réelle ($P_{ist}$) de puissance est modifiée dans sa linéarité, en particulier de façon logarithmique.

## FIG. 1

$V_{in}$

11

k

$\Sigma$

$V_0$

10

+ $V_{cc}$

$V_{in}$

8bit, 10bit

digitale Daten $W_{out}$

ADC ADU

$V_{ref}$

Steuerleitungen

GND 20

## FIG. 2

$V_{out}$

11

k

$\Sigma$

$V_0$

10

+ $V_{cc}$

$V_{out}$

8bit, 16bit

digitale Daten

DAC DAU

$W_{in}$

$V_{ref}$

Steuerleitungen

GND 30

## FIG. 3

$W_{in}$ $W_{out}$

$W_{max}$

b

$k_{DAU}$

$k_{ADU}$

a

DAU

ADU

0

$V_{max}$

$V_{in}$ $V_{out}$

## FIG. 4

$V_{in}/V_{out}$

$V_{in}/V_{out}$

1

R

T

R

R

12

R

R

$V_0$

13

$V_{ref}$

$$k = \frac{R}{R+T} = \frac{1}{1+T/R}$$

$$\text{mit } T = R \rightsquigarrow k = \frac{1}{2}$$

11